(19)

Europäisches
Patentamt
European
Patent Office
Office européen
des brevets

(11) **EP 2 033 996 A1**

(12) **EUROPEAN PATENT APPLICATION**

(43) Date of publication:
**11.03.2009 Bulletin 2009/11**

(51) Int Cl.:
*C09J 7/02* $^{(2006.01)}$

(21) Application number: **08015713.4**

(22) Date of filing: **05.09.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **06.09.2007 JP 2007231828**

(71) Applicant: **Nitto Denko Corporation Ibaraki-shi, Osaka 567-8680 (JP)**

(72) Inventor: **Takahashi, Tomokazu Ibaraki-shi Osaka 567-8680 (JP)**

(74) Representative: **Grünecker, Kinkeldey, Stockmair & Schwanhäusser Anwaltssozietät Leopoldstrasse 4 80802 München (DE)**

(54) **Pressure-sensitive adhesive sheet for dicing and dicing method**

(57)     The present invention relates to a pressure-sensitive adhesive sheet for dicing comprising a substrate layer and an active energy ray-curable pressure-sensitive adhesive layer provided on the substrate layer, in which the active energy ray-curable pressure-sensitive adhesive layer has a gel fraction before irradiation with an active energy ray of 50% or more. Furthermore, the invention also provides a method for dicing an adherend, which comprises attaching the pressure-sensitive adhesive sheet for dicing to an adherend, followed by cutting the adherend using a round blade. The pressure-sensitive adhesive sheet for dicing of the invention is free from leaving any adhesive residue on chips, from peeling of the pressure-sensitive adhesive sheet from the ring for fixing it, as well as from leaving any paste residue on the ring.

## FIGURE

EP 2 033 996 A1

**Description**

**FIELD OF THE INVENTION**

The present invention relates to a pressure-sensitive adhesive sheet for dicing. More specifically, it relates to a pressure-sensitive adhesive sheet for dicing to be used for dicing a semiconductor wafer made of a material such as silicon or gallium-arsenic, a semiconductor package, glass, or ceramics.

**BACKGROUND OF THE INVENTION**

A semiconductor wafer made of a material such as silicon, germanium, or gallium-arsenic is produced in a large-diameter form, thereafter subjected to back grinding so as to result in a given thickness, further subjected to backside processing (e.g., etching, polishing, etc.) according to the necessity, and then cut (diced) thereby producing a semiconductor chip. More specifically, a pressure-sensitive adhesive sheet for dicing is attached to the backside of the semiconductor wafer (mounting step), this wafer is cut into device pieces (chips) and subsequently subjected to various steps such as a cleaning step, an expanding step, and a pickup step to form chips. With regard to the semiconductor wafer, by adhering and fixing it with a pressure-sensitive adhesive sheet for dicing in the process of a semiconductor chip production, generation of chipping and/or flying of the chips can be suppressed and also breakage of the semiconductor wafer can be suppressed.

As the pressure-sensitive adhesive sheet for dicing, the mainstream is one having a structure where a pressure-sensitive adhesive layer having a thickness of about 1 to 50 $\mu$m is laminated on a substrate composed of a plastic film or the like by applying an acrylic pressure-sensitive adhesive on the substrate, followed by drying the same. The pressure-sensitive adhesive sheet for dicing is required to have adhesive strength sufficient to prevent the semiconductor wafer from peeling from the sheet in the dicing step. On the other hand, the adhesive strength is required to be low in such a degree that, in the pickup step after dicing, the semiconductor wafer can be easily peeled from the sheet without breakage. In order to manifest the antithetical pressure-sensitive adhesive properties, there has been developed a pressure-sensitive adhesive sheet wherein a pressure-sensitive adhesive layer is cured by irradiation with an active energy ray such as an ultraviolet ray to lower adhesive strength and hence the peeling is more easily achieved (see, JP-A-2-187478).

Moreover, in the dicing step, since not only an adherend but also a part of the pressure-sensitive adhesive sheet for dicing are cut together, a part of the pressure-sensitive adhesive is rolled up by a round blade to attach to the adherend (an adhesive residue left on the chip), which causes decrease in yield. Furthermore, after dicing, in the pickup step where the cut adherend is collected from the pressure-sensitive adhesive sheet for dicing, expanding is performed wherein the pressure-sensitive adhesive sheet for dicing is expanded to broaden the distance between the cut adherends in order to facilitate the collection of the cut adherends. On this occasion, since there is a fear that the pressure-sensitive adhesive sheet for dicing may peel from a ring which fixes the pressure-sensitive adhesive sheet to cause a pickup failure, there has been conducted a procedure that the ring part is not irradiated with an active energy ray and the pressure-sensitive adhesive layer at the part is kept in an uncured state to maintain a high adhesive strength. However, the peeling from the ring sometimes occurs even when the procedure is applied.

Furthermore, after the pickup, at the time of removing the pressure-sensitive adhesive sheet for dicing which becomes unnecessary from the ring, a paste residue is left on the ring owing to cohesive failure of the pressure-sensitive adhesive, particularly when the pressure-sensitive adhesive layer is not irradiated with an active energy ray and thus is in an uncured state. Namely, it is a current situation that there has not yet been found a pressure-sensitive adhesive sheet for dicing which is capable of controlling adhesiveness so that a sufficiently strong adhesiveness is exhibited when adhesiveness is required and an easy peelability is exhibited when peeling is required, is capable of preventing attachment of the pressure-sensitive adhesive to the adherend through the rolling-up of a part of the pressure-sensitive adhesive due to the round blade at dicing of the adherend, and enables easy peeling of the unnecessary pressure-sensitive adhesive sheet without fouling the adherend and ring at the peeling of the sheet.

**SUMMARY OF THE INVENTION**

Accordingly, an object of the invention is to provide a pressure-sensitive adhesive sheet for dicing having an active energy ray-curable pressure-sensitive adhesive layer which is capable of controlling adhesiveness so that a strong adhesiveness is exhibited when adhesiveness is required and an easy peelability is exhibited when peeling is required, is capable of preventing an attachment of the pressure-sensitive adhesive to the adherend through rolling-up of a part of the pressure-sensitive adhesive with a round blade at the dicing of the adherend, enables easy peeling of the adherend from the pressure-sensitive adhesive sheet without peeling of the pressure-sensitive adhesive sheet from the ring for fixing the pressure-sensitive adhesive sheet as well as without fouling the adherend in the pickup step, and enables peeling of the pressure-sensitive adhesive sheet without fouling the ring for fixing the pressure-sensitive adhesive sheet after the completion of the pickup step. Namely, an object of the invention is to provide a pressure-sensitive adhesive sheet for dicing which is free from leaving any adhesive residue on chips, from peeling of the pressure-sensitive adhesive sheet from the ring for fixing it, as well as from leaving any paste residue on the ring.

As a result of extensive studies for solving the above problem, the present inventor has found that, when the gel fraction of the active energy ray-curable pressure-sensitive adhesive layer before irradiation with an active energy ray is regulated to 50% or more, an attachment of the pressure-sensitive adhesive to the adherend through rolling-up of a part of the pressure-sensitive adhesive with a round blade at the dicing of the adherend is prevented, peeling of the adherend can be achieved with ease and without fouling by irradiation with an active energy ray beforehand, and also the problems of the peeling of the pressure-sensitive adhesive sheet from the ring for fixing the pressure-sensitive adhesive sheet and the paste residue left on the ring can be solved. Thus, the invention has been accomplished.

Namely, the invention provides a pressure-sensitive adhesive sheet for dicing comprising a substrate layer and an active energy ray-curable pressure-sensitive adhesive layer provided on the substrate layer, wherein the active energy ray-curable pressure-sensitive adhesive layer has a gel fraction before irradiation with an active energy ray of 50% or more.

Moreover, the active energy ray-curable pressure-sensitive adhesive layer may be an active energy ray-curable pressure-sensitive adhesive layer containing at least an acrylic copolymer having a polymerizable carbon-carbon double bond at the side chain thereof. In addition, it may also be an active energy ray-curable pressure-sensitive adhesive layer containing at least an acrylic copolymer and an active energy ray-curable oligomer wherein the amount of the oligomer is 1 to 100 parts by weight based on 100 parts by weight of the acrylic copolymer. Furthermore, the weight-average molecular weight of the acrylic copolymer contained in the active energy ray-curable pressure-sensitive adhesive layer is preferably 300,000 or more, and the active energy ray-curable pressure-sensitive adhesive layer preferably contains at least 0.5 to 10 parts by weight of a crosslinking agent based on 100 parts by weight of the acrylic copolymer.

Furthermore, the invention also provides a method for dicing an adherend, which comprises attaching the above-mentioned pressure-sensitive adhesive sheet for dicing to an adherend, followed by cutting the adherend using a round blade.

According to the pressure-sensitive adhesive sheet for dicing of the invention, since an active energy ray-curable pressure-sensitive adhesive layer having a gel fraction before irradiation with an active energy ray of 50% or more is employed, cohesive force of the pressure-sensitive adhesive is strong, whereby an attachment of the pressure-sensitive adhesive to an adherend through rolling-up of a part of the pressure-sensitive adhesive with a round blade at the dicing of the adherend can be prevented. Furthermore, the sheet has a strong adhesiveness before irradiation with an active energy ray and whereby the peeling of the pressure-sensitive adhesive sheet from the ring for fixing the pressure-sensitive adhesive sheet can be prevented and then, adhesive strength can be remarkably lowered by irradiation with an active energy ray to achieve easy peeling of the adherend without fouling the adherend. Furthermore, with regard to the ring part which is not irradiated with an active energy ray, cohesive failure of the pressure-sensitive adhesive does not occur and thus the pressure-sensitive adhesive sheet for dicing can be peeled without leaving any paste residue on the ring. Therefore, the effort for removing the left paste residue can be omitted and hence production efficiency can be remarkably improved.

## BRIEF DESCRIPTION OF THE DRAWINGS

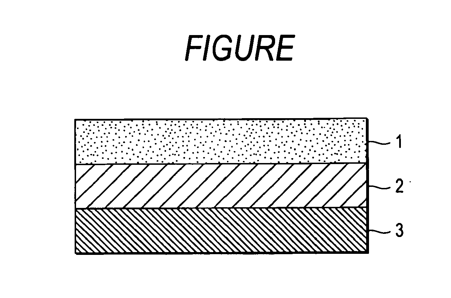

FIG. 1 is a schematic cross-sectional view illustrating one embodiment of the pressure-sensitive adhesive sheet for dicing of the invention.

Description of the Reference Numerals and Signs

1    Substrate layer
2    Active energy ray-curable pressure-sensitive adhesive layer
3    Separator

## DETAILED DESCRIPTION OF THE INVENTION

The following will describe embodiments for carrying out the invention in detail with reference to drawings, if necessary. FIG. 1 is a schematic cross-sectional view illustrating one embodiment of the pressure-sensitive adhesive sheet for dicing of the invention.

The pressure-sensitive adhesive sheet for dicing of the invention has at least one layer of an active energy ray-curable pressure-sensitive adhesive layer and has a substrate layer in view of handling properties, workability, and the like. Moreover, in addition to the substrate layer and the active energy ray-curable pressure-sensitive adhesive layer, the pressure-sensitive adhesive sheet of the invention may also have other optional layers such as an under-coat layer and an adhesive layer. In this connection, the pressure-sensitive adhesive surface of the pressure-sensitive adhesive sheet of the invention may be protected through attachment of a separator (release liner) thereto until the sheet is used.

In the embodiment of FIG. 1, an active energy ray-curable pressure-sensitive adhesive layer 2 is laminated on a substrate layer 1 and the active energy ray-curable pressure-sensitive adhesive layer 2 is protected with a separator 3. However, the pressure-sensitive adhesive sheet for dicing according to the invention is not limited thereto and a plurality of the active energy ray-curable pressure-sensitive adhesive layers may be laminated or a pressure-sensitive adhesive layer may be provided on both sides of the substrate layer. Moreover, the pressure-sensitive adhesive sheet according to the invention may be in a suitable form, such as a sheet form or a roll form, depending on application fields. For example, in the case where it is used as a pressure-sensitive adhesive sheet for dicing used at a dicing of a semiconductor wafer, a sheet which has been cut into given shapes beforehand is suitable used.

Active energy ray-curable pressure-sensitive adhesive layer

The pressure-sensitive adhesive sheet for dicing of the invention has a structure where an active energy ray-curable pressure-sensitive adhesive layer is laminated on a substrate layer. The active energy ray-curable pressure-sensitive adhesive layer exhibits a strong adhesiveness before irradiation with an active energy ray and is cured by irradiation with an active energy ray to remarkably lower the adhesiveness, so that easy peelability is exhibited. Accordingly, the pressure-sensitive adhesive sheet of the invention can be a pressure-sensitive adhesive sheet which has a strong adhesiveness in a state of non-irradiation with an active energy ray but acquires easy peelability by irradiation with an active energy ray in the case where peeling is required. In the invention, the active energy ray means, for example, an ultraviolet ray, a visible light, an infrared ray, a radioactive ray, or the like.

Although the active energy ray-curable pressure-sensitive adhesive layer of the invention is preferably located on the surface layer (outermost layer) of the pressure-sensitive adhesive sheet for dicing, it may be located at any inner layer other than the surface layer. In that case, any layer containing an active energy ray-curable pressure-sensitive adhesive layer and having a role of imparting easy peelability to the outermost layer of the sheet may be regarded as the active energy ray-curable pressure-sensitive adhesive layer of the invention.

The active energy ray-curable pressure-sensitive adhesive layer according to the invention preferably has a gel fraction of 50% or more before irradiation with an active energy ray and, in particular, the gel fraction is more preferably 60% or more, particularly preferably 70% or more. When the gel fraction is less than 50%, there is a tendency that a part of the pressure-sensitive adhesive is rolled up with a round blade to attach to an adherend (chip or the like) at the dicing of the adherend and further, with regard to the ring part which is not irradiated with an active energy ray, after completion of the pickup step, a paste residue tends to be left at the time when the unnecessary pressure-sensitive adhesive sheet for dicing is peeled from the ring. The upper limit of the gel fraction is 100%. In this connection, the gel fraction means a ratio of ethyl acetate-insoluble ingredient(s) in the constituents of the pressure-sensitive adhesive when the adhesive is immersed in ethyl acetate for 1 week.

As a method of regulating the gel fraction to 50% or more, specifically, it can be regulated by optimizing the amount of an external crosslinking agent contained in the pressure-sensitive adhesive constituting the active energy ray-curable pressure-sensitive adhesive layer as well as by optimizing the amount of crosslinking points in the polymer constituting the pressure-sensitive adhesive.

The active energy ray-curable pressure-sensitive adhesive layer according to the invention has a nature of being cured by irradiation with an active energy ray. In order to exhibit the active energy ray-curability, it is sufficient to have a polymerizable carbon-carbon double bond. For example, there may be used an active energy ray-curable pressure-sensitive adhesive containing a polymer having a polymerizable carbon-carbon double bond at the side chain or at the end of the main chain thereof as a base polymer or may be used an addition-type active energy ray-curable pressure-sensitive adhesive wherein a monomer ingredient or oligomer ingredient having a polymerizable carbon-carbon double bond at the side chain thereof is added to a pressure-sensitive adhesive.

Examples of the active energy ray-curable pressure-sensitive adhesive containing a polymer having a polymerizable carbon-carbon double bond at the side chain or at the end of the main chain thereof as a base polymer include pressure-sensitive adhesives composed of one or more known pressure-sensitive adhesives such as rubber pressure-sensitive adhesives, acrylic pressure-sensitive adhesives, vinyl alkyl ether pressure-sensitive adhesives, silicone pressure-sensitive adhesives, polyester pressure-sensitive adhesives, polyamide pressure-sensitive adhesives, urethane pressure-sensitive adhesives, styrene-diene block copolymer pressure-sensitive adhesives, and creep property-improved pressure-sensitive adhesives wherein a thermally melting resin having a melting point of about 200°C or lower is mixed with the above pressure-sensitive adhesives (see, e.g., JP-A-56-61468, JP-A-61-174857, JP-A-63-17981, JP-A-56-13040, etc.). Of these, an acrylic pressure-sensitive adhesive is preferred. The pressure-sensitive adhesive may contain, in addition to the pressure-sensitive adhesive component(s) (base polymer), suitable additives such as a crosslinking agent (e.g., a polyisocyanate, an alkyl ether etherified melamine-based crosslinking agent, etc.), a tackifier (e.g., solid or liquid one composed of a rosin derivative resin, a polyterpene resin, a petroleum resin, an oil-soluble phenol resin, or the like), a plasticizer, a filler, and an antiaging agent.

In general, examples of the acrylic polymer include acrylic polymers (homopolymers or copolymers) using one or more compounds of (meth)acrylic acid alkyl esters (e.g., $C_{1-20}$ alkyl esters, such as methyl ester, ethyl ester, propyl ester, isopropyl ester, butyl ester, isobutyl ester, s-butyl ester, t-butyl ester, pentyl ester, hexyl ester, heptyl ester, octyl ester, 2-ethylhexyl ester, isooctyl ester, isodecyl ester, dodecyl ester, tridecyl ester, pentadecyl ester, hexadecyl ester, heptadecyl ester, octadecyl ester, nonadecyl ester, and eicosyl ester) as monomer ingredient(s). As the other pressure-sensitive adhesive, a rubber pressure-sensitive adhesive using natural rubber or any of various synthetic rubbers as a base polymer may be contained.

The acrylic polymer may optionally contain units corresponding to other monomer ingredient(s) copolymerizable with the above (meth)acrylic acid alkyl esters for the purpose of modifying cohesive force, heat resistance, crosslinking ability, etc. Examples of such monomer ingredients include carboxyl group-containing monomers such as acrylic acid, methacrylic acid, carboxyethyl (meth)acrylate, carboxypentyl (meth)acrylate, itaconic acid, maleic acid, fumaric acid, and crotonic acid; acid anhydride monomers such as maleic anhydride and itaconic anhydride; hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)acrylate; sulfonic acid group-containing monomers such as styrenesulfonic acid, allylsulfonic acids, 2-(meth)acrylamido-2-methylpropanesulfonic acid, (meth)acrylamidopropanesulfonic acid, sulfopropyl (meth)acrylate, and (meth)acryloyloxynaphthalenesulfonic acid; phosphoric acid group-containing monomers such as 2-hydroxyethyl acryloylphosphate; (n-substituted)amide-based monomers such as (meth)acrylamide, N,N-dimethyl(meth)acrylamide, N-butyl(meth)acrylamide, N-methylol(meth)acrylamide, and N-methylolpropane (meth)acrylamide; aminoalkyl (meth)acrylate-based monomers such as aminoethyl (meth)acrylate, N,N-dimethylaminoethyl (meth)acrylate, and t-butylaminoethyl (meth)acrylate; alkoxyalkyl (meth)acrylate-based monomers such as methoxyethyl (meth)acrylate and ethoxyethyl (meth)acrylate; meleimido-based monomers such as N-cyclohexylmaleimide, N-isopropylmaleimide, N-laurylmaleimide, and N-phenylmaleimide; itaconimide-based monomers such as N-methylitaconimide, N-ethylitaconimide, N-butylitaconimide, N-octylitaconimide, N-2-ethylhexylitaconimide, N-cyclohexylitaconimide, and N-laurylitaconimide; succinimide-based monomers such as N-(meth)acryloyloxymethylenesuccinimide, N-(meth)acryloyl-6-oxyhexamethylenesuccinimide, and N-(meth)acryloyl-8-oxyoctamethylenesuccinimide; vinylic monomers such as vinyl acetate, vinyl propionate, N-vinylpyrrolidone, methylvinylpyrrolidone, vinylpyridine, vinylpiperidone, vinylpyrimidine, vinylpiperazine, vinylpyrazine, vinylpyrrole, vinylimidazole, vinyloxazole, vinylmorpholine, N-vinylcarboxylic acid amides, styrene, $\alpha$-methylstyrene, and N-vinylcaprolactam; cyanoacrylate monomers such as acrylonitrile and methacrylonitrile; epoxy group-containing acrylic monomers such as glycidyl (meth)acrylate; glycol-based acrylic ester monomers such as (poly)ethylene glycol (meth)acrylate, (poly)propylene glycol (meth)acrylate, methoxyethylene glycol (meth)acrylate, and methoxypolypropylene glycol (meth)acrylate; acrylic ester-based monomers having a heterocyclic ring, a halogen atom, a silicon atom, or the like, such as tetrahydrofurfuryl (meth)acrylate, fluorine (meth)acrylate, and silicone (meth)acrylate; polyfunctional monomers such as hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylates, polyester acrylates, and urethane acrylates; olefinic monomers such as isoprene, butadiene, and isobutylene; and vinyl ether-based monomers such as vinyl ethers.

The acrylic copolymer is obtained by polymerizing the above monomer ingredients and can be synthesized by any method of solution polymerization, emulsion polymerization, bulk polymerization, suspension polymerization, and the like. With regard to the pressure-sensitive adhesive according to the invention, a smaller content of a low-molecular-weight substance(s) is preferable from the viewpoint of enhancing the cohesive force of the pressure-sensitive adhesive by increasing the gel fraction of the pressure-sensitive adhesive to prevent the fouling of semiconductor chips, rings, and the like. Thus, the weight-average molecular weight of the acrylic polymer is, for example, 300,000 or more, preferably 500,000 or more, particularly preferably about 800,000 to 3,000,000. When the weight-average molecular weight is less than 300,000, the gel fraction decreases and, as a result, the fouling of semiconductor chips, rings, and the like may be caused in some cases.

The acrylic polymer may optionally contain a polyfunctional monomer or the like as a monomer ingredient for copolymerization for the purpose of crosslinking the polymer. The crosslinking can improve cohesive force, thermal resistance, adhesiveness, and the like of the pressure-sensitive adhesive and also can increase the weight-average molecular weight, so that it is preferred in view of inhibiting the fouling of the chips and the like. Examples of such a polyfunctional monomer include hexanediol (meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy (meth)acrylates, polyester (meth)acrylates, and urethane (meth)acrylates. These polyfunctional monomers may be used alone or in combination of two or more thereof.

In the case where an acrylic polymer having a polymerizable carbon-carbon double bond(s) at the side chain or at the end of the main chain thereof is used as the base polymer, such a base polymer can be obtained by employing the above acrylic copolymer as a basic skeleton and introducing the polymerizable carbon-carbon double bond(s) to the basic skeleton. In the case where the base polymer has a polymerizable carbon-carbon double bond(s), an active energy ray-curable monomer or oligomer ingredient may not be or may be added separately. Therefore, the acrylic polymer having a polymerizable carbon-carbon double bond(s) may not contain any oligomer ingredient and the like that is a low-molecular-weight ingredient or may not contain a large amount of the ingredient, so that there can be no migration of the oligomer ingredient or the like in the pressure-sensitive adhesive with time and a pressure-sensitive adhesive layer having a stable layer structure can thus be formed.

The method for introducing a polymerizable carbon-carbon double bond into the acrylic polymer is not particularly limited, and may be selected from various methods. For example, there may be mentioned a method of copolymerizing a monomer having a functional group as an acrylic copolymer beforehand, and then subjecting a compound having a functional group reactive with the functional group and a polymerizable carbon-carbon double bond to a condensation or addition reaction with the resultant polymer, while keeping the active energy ray-curability of the polymerizable carbon-carbon double bond.

Examples of the combination of highly reactive functional groups include a carboxylic acid group and an epoxy group; a carboxylic acid group and an aziridine group; and a hydroxyl group and an isocyanate group. Of these combinations of functional groups, the combination of a hydroxyl group and an isocyanate group is preferable from the viewpoint of the easiness of reaction tracing. Moreover, when the combination of these functional groups is selected, each of the functional groups may be present in either one of the acrylic polymer or the compound having the polymerizable carbon-carbon double bond. Particularly, it is preferable that the acrylic polymer has a hydroxyl group and the compound having the polymerizable carbon-carbon double bond has an isocyanate group. Examples of the compound having the functional group and the polymerizable carbon-carbon double bond in this case include methacryloyl isocyanate, 2-methacryloyloxyethyl isocyanate, and m-isopropenyl-$\alpha,\alpha$-dimethylbenzyl isocyanate. Moreover, as the acrylic copolymer, an acrylic copolymer obtained by copolymerization with any one of the hydroxyl-containing monomers exemplified above, or an ethereal compound such as 2-hydroxyethyl vinyl ether, 4-hydroxybutyl vinyl ether, or diethylene glycol monovinyl ether may be used. The acrylic copolymer having the polymerizable carbon-carbon double bond can be used solely or in combination of two or more thereof.

The addition-type active energy ray-curable pressure-sensitive adhesive wherein a monomer ingredient or oligomer ingredient having a polymerizable carbon-carbon double bond at the side chain thereof is mixed with a pressure-sensitive adhesive can be obtained by mixing an active energy ray-curable monomer ingredient or oligomer ingredient with the pressure-sensitive adhesive. As the pressure-sensitive adhesive, there may be mentioned those the same as the examples mentioned as the active energy ray-curable pressure-sensitive adhesive having a polymerizable carbon-carbon double bond at the side chain or at the end thereof (however, inclusive of those having no polymerizable carbon-carbon double bond). Of these, an acrylic pressure-sensitive adhesive is preferable. As the active energy ray-curable monomer ingredient and oligomer ingredient, there may be used a monomer or oligomer having a functional group having a nature of crosslinking by irradiation with an active energy ray, such as a carbon-carbon double bond. Particularly, a monomer or oligomer having six or more carbon-carbon double bonds on average in one molecule thereof is preferable. Examples of the monomer or oligomer include trimethylolpropane tri(meth)acrylate, pentaerythritol tri(meth)acrylate, dipentaerythritol hexa(meth)acrylate, tetraethylene glycol di(meth)acrylate, 1,6-hexanediol di(meth)acrylate, neopentyl glycol di(meth)acrylate, ester compounds of (meth)acrylatic acid and polyhydric alcohols, ester acrylate oligomers, 2-propenyl-3-butenyl cyanurate, isocyanurate, and isocyanurate compounds. Of these, dipentaerythritol hexa(meth)acrylate is preferable. The active energy ray-curable monomer ingredient or oligomer ingredient may be used solely or in combination of two or more thereof.

The mixing amount of the active energy ray-curable monomer or oligomer ingredient is not particularly limited, but is preferably 1 to 100 parts by weight based on 100 parts by weight of the acrylic copolymer in the pressure-sensitive adhesive from the viewpoint of increasing the gel fraction of the pressure-sensitive adhesive to enhance the cohesive force of the pressure-sensitive adhesive. Particularly, the amount is preferably 5 to 50 parts by weight, particularly preferably 10 to 30 parts by weight. When the mixing amount of the monomer or oligomer ingredient exceeds 100 parts by weight based on 100 parts by weight of the acrylic copolymer, the content of the low-molecular-weight substance becomes too large and thus the weight-average molecular weight decreases. As a result, the gel fraction decreases and a paste residue is left on the chip and ring, which may cause the fouling of semiconductor wafer and the like in some cases. On the other hand, when the mixing amount of the monomer or oligomer ingredient is less than 1 part by weight based on 100 parts by weight of the acrylic copolymer, the resulting product may have no active energy ray-curability and thus cannot be easily peeled in some cases even when irradiated with an active energy ray. The viscosity of the active energy ray-curable monomer or oligomer ingredient is not particularly limited.

In view of the balance between appropriate adhesive strength before irradiation with the active energy ray and decrease in adhesive strength after the irradiation treatment, the pressure-sensitive adhesive is preferably a pressure-sensitive adhesive containing, as a base polymer, a polymer having a dynamic elastic modulus ranging from 50,000 to 10,000,000 dyn/cm$^2$ at the temperature range of ordinary temperature to 150°C.

Moreover, an external crosslinking agent can be suitably used for the purpose of increasing the weight-average molecular weight of the acrylic copolymer or the like as a base polymer and regulating the gel fraction. Examples of the external crosslinking agent include polyisocyanate compounds, epoxy compounds, aziridine compounds, melamine resins, urea resins, anhydride compounds, polyamine compounds, and carboxyl group-containing copolymers. As an external crosslinking method, there may be mentioned a method of reacting the external crosslinking agent with the acrylic copolymer or the like. In the case where the external crosslinking agent is used, the amount thereof is, for example, 0.5 to 10 parts by weight based on 100 parts by weight of the base polymer to be crosslinked, and particularly, it is preferable to mix the crosslinking agent in an amount of 1 to 5 parts by weight.

In the case where an ultraviolet-curable pressure-sensitive adhesive is used as the active energy ray-curable pressure-sensitive adhesive, it is preferable to add a photopolymerization initiator. The photopolymerization initiator is activated by irradiation with an ultraviolet ray to generate a radial. Then, the generated radical has a function of activating the base polymer containing a polymerizable unsaturated bond to initiate polymerization and to cure the pressure-sensitive adhesive. Examples of the photopolymerization initiator include benzoin alkyl ethers such as benzoin methyl ether, benzoin propyl ether, benzoin isopropyl ether, and benzoin isobutyl ether; aromatic ketones such as benzil, benzoin, benzophenone, and α-hydroxycyclohexyl phenyl ketone; aromatic ketals such as benzyl dimethyl ketal; polyvinylbenzophenone; and thioxanthones such as chlorothioxanthone, dodecylthioxanthone, dimethylthioxanthone, and diethylthioxanthone.

The amount of the photopolymerization initiator to be used is, for example, about 0.1 to 20 parts by weight, preferably about 0.5 to 10 parts by weight based on 100 parts by weight of the acrylic polymer which constitutes the pressure-sensitive adhesive.

The thickness of the active energy ray-curable pressure-sensitive adhesive layer is not particularly limited but is preferably in the range of 1 to 50 μm, more preferably in the range of 3 to 20 μm. The adherend attached to the pressure-sensitive adhesive sheet for dicing sometimes vibrates at dicing the same. When the vibration range is large, generation of chipping at the cutting of the adherend may be caused. When the thickness of the active energy ray-curable pressure-sensitive adhesive layer exceeds 50 μm, the vibration range of the vibration generated at dicing the adherend becomes too large and the frequency of occurrence of chipping increases. On the other hand, when the thickness of the active energy ray-curable pressure-sensitive adhesive layer is less than 1 μm, the adherend cannot be surely held thereon at dicing and the adherend may be broken in some cases.

According to the active energy ray-curable pressure-sensitive adhesive layer of the invention, since an active energy ray-curable pressure-sensitive adhesive having a gel fraction of 50% or more is used, the cohesive force of the pressure-sensitive adhesive constituting the active energy ray-curable pressure-sensitive adhesive layer is high and hence the attachment of the pressure-sensitive adhesive to the adherend through rolling-up of a part of the pressure-sensitive adhesive with the round blade at the dicing of the adherend can be prevented. Moreover, the pressure-sensitive adhesive layer has a strong adhesiveness and hence the peeling (ring detachment) of the pressure-sensitive adhesive sheet for dicing from the ring which fixes the pressure-sensitive adhesive sheet can be prevented at the time when expanding of the pressure-sensitive adhesive sheet is conducted for broadening the distance between the adherends in the pickup step where the adherend is collected from the pressure-sensitive adhesive sheet after the dicing. After completion of the dicing step, curing is achieved by irradiation with an active energy ray and peeling (pickup step) can be easily performed without fouling the adherend. Furthermore, since the active energy ray-curable pressure-sensitive adhesive having a gel fraction of 50% or more is used, the pressure-sensitive adhesive sheet for dicing which becomes unnecessary after the completion of the pickup step can be easily peeled from the ring, which is not irradiated with an active energy ray, without leaving any paste residue.


Substrate layer

The substrate layer of the invention has a role as a parental material for the strength of the pressure-sensitive adhesive sheet for dicing. The substrate constituting the substrate layer is not particularly limited and it is possible to use various substrates. For example, there can be used an appropriate thin article, e.g., a fiber-based substrate such as a fabric, a non-woven fabric, a felt, or a net; a paper-based substrate such as various kind of paper; a metal-based substrate such as a metal foil or a metal plate; a plastic-based substrate such as a plastic film or sheet; a rubber-based substrate such as a rubber sheet; a foamed article such as a foamed sheet; a laminate thereof; or the like. Of these, a plastic-based substrate can be suitably used. Examples of the plastic-based substrate include polyesters (polyethylene terephthalate, polyethylene naphthalate, and polybutylene terephthalate, polybutylene naphthalate, etc.), polyolefins (low-density polyethylene, linear polyethylene, medium-density polyethylene, high-density polyethylene, ultralow-density polyethylene, propylene random copolymers, propylene block copolymers, propylene homopolymer, polybutene, polymethylpentene, ethylene/propylene copolymers, etc.), ethylene/vinyl acetate copolymers, ionomer resins, ethylene/ (meth)acrylic acid copolymers, ethylene/(meth)acrylic ester (random or alternating) copolymers, ethylene/butene copolymers, ethylene/hexene copolymers, polyurethanes, polyether ketones, polyvinyl alcohol, polyvinylidene chloride, polyvinyl chloride, vinyl chloride/vinyl acetate copolymers, polyvinyl acetate, polyamides, polyimides, cellulosic resins, fluorine-based resins, silicone resins, polyethers, polystyrene-base resins (polystyrene, etc.), polycarbonates, polyether sulfones, and polymers obtained by crosslinking these polymers. Moreover, a functional monomer or a modifying monomer can be suitably bonded to these materials according to the necessity.

The substrate constituting the substrate layer of the invention can be used solely or in combination of two or more of the above substrates. Furthermore, in order to impart an antistatic function to the substrate layer, there may be provided a vapor-deposition layer of a conductive substance composed of a metal, an alloy, or an oxide thereof on the above substrate. The thickness of the vapor-deposition layer is, for example, about 30 to 500 angstroms. In this connection, since the pressure-sensitive adhesive layer according to the invention has a property of being cured by irradiation of an active energy ray, it is preferable for the substrate layer according the invention to have a property of transmitting at least a part of an energy ray (ultraviolet ray, visible light, infrared ray, radioactive ray, etc.).

The thickness of the substrate layer is not particularly limited but, for example, is 10 to 300 $\mu$m, preferably about 30 to 200 $\mu$m.

As a method for film formation of the substrate layer, any of known and conventional methods can be adopted and, for example, calendering film formation, casting film formation, inflation extrusion, T-die extrusion, or the like can be suitably employed.

The substrate layer may be a single layer or a multiple layer. Moreover, in the case where the layer has a multiple layer structure, individual layers may be constituted of the same substrate or may be laminated with layers constituted by different substrates. In the case where the substrate layer has a multiple layer structure, as a production method thereof, the layer can be produced by a conventional film lamination method such as co-extrusion method or dry lamination method using the above substrate(s). Moreover, the substrate may be used in an unstretched state, or may be subjected to a uniaxial stretching treatment or a biaxial stretching treatment according to the necessity.

The surface of the substrate may have undergone a conventional surface treatment, e.g., an oxidation treatment by a chemical or physical method, such as a chromic acid treatment, an ozone exposure treatment, flame exposure treatment, a high-voltage electric-shock exposure treatment, or an ionizing radiation treatment in order to enhance adhesiveness with the active energy ray-curable pressure-sensitive adhesive layer and the like according to the necessity. In addition, if necessary, a common physical or chemical treatment such as a matting treatment, a corona discharge treatment, a primer treatment, or a crosslinking treatment may be applied.

Pressure-sensitive adhesive sheet for dicing

In the pressure-sensitive adhesive sheet for dicing of the invention, the active energy ray-curable pressure-sensitive adhesive layer can be provided on one side or both sides of the substrate layer. Furthermore, in addition to the active energy ray-curable pressure-sensitive adhesive layer and the substrate layer, for example, an intermediate layer such as an undercoat layer or an adhesive layer may be provided between the active energy ray-curable pressure-sensitive adhesive layer and the substrate layer.

As a specific layer constitution of the pressure-sensitive adhesive sheet for dicing of the invention, for example, there may be preferably exemplified (1) a constitution in which an active energy ray-curable pressure-sensitive adhesive layer A and a substrate layer are laminated in this order; (2) a constitution in which an active energy ray-curable pressure-sensitive adhesive layer A, a substrate layer and an active energy ray-curable pressure-sensitive adhesive layer B are laminated in this order; and the like, but the invention is not limited thereto.

As a method of forming the active energy ray-curable pressure-sensitive adhesive layer on the substrate layer, any of known and conventional methods can be adopted. For example, there may be used a method of directly applying an active energy ray-curable pressure-sensitive adhesive constituting the active energy ray-curable pressure-sensitive adhesive layer on the substrate layer; a method of applying the active energy ray-curable pressure-sensitive adhesive on a sheet (separator or the like) coated with a release agent, drying the resulting sheet to form an active energy ray-curable pressure-sensitive adhesive layer, and subsequently transferring the layer onto the substrate layer; or the like method.

According to the pressure-sensitive adhesive sheet for dicing of the invention, the attachment of the pressure-sensitive adhesive to the adherend through rolling-up of a part of the pressure-sensitive adhesive with the round blade at the dicing of the adherend can be prevented. Moreover, a strong adhesiveness is exhibited when adhesiveness is required and an easy peelability by which easy peeling of the adherend without fouling the adherend is enabled is exhibited by irradiation with an active energy ray when peeling is required. Furthermore, in the expanding step, the peeling (ring detachment) of the pressure-sensitive adhesive sheet for dicing from the ring which fixes the pressure-sensitive adhesive sheet can be prevented. At the time when the pressure-sensitive adhesive sheet for dicing of the invention which becomes unnecessary is peeled from the ring for dicing which is not irradiated with an active energy ray, the sheet can be easily peeled without fouling the ring. Namely, the sheet can be suitably employed in the process wherein it is attached to a semiconductor wafer made of a material such as silicon, germanium, or gallium-arsenic (mounting step), the semiconductor wafer is cut into device pieces (dicing step), and the pieces are subsequently subjected to various steps such as a cleaning step, an expanding step, and a pickup step to form chips, without problems of the adhesive residue left on the chips, the peeling from the rings, and the paste residue left on the rings. Furthermore, according to the pressure-sensitive adhesive sheet for dicing of the invention, the effort for removing the left paste residue can be omitted and hence production efficiency can be remarkably improved. Separator

For the pressure-sensitive adhesive sheet for dicing of the invention, a separator (release liner) may be provided on the surface of the active energy ray-curable pressure-sensitive adhesive layer in view of smoothing and protection of the surface of the active energy ray-curable pressure-sensitive adhesive layer, label processing, and blocking prevention. The separator is to be peeled when the pressure-sensitive adhesive sheet for dicing is attached to the adherend and thus is not necessarily provided. The separator to be used is not particularly limited and a known and conventional release paper and the like can be used. For example, there can be employed a substrate having a release layer such as a plastic film or paper which is surface-treated with a release agent such as silicone-based, long-chain alkyl-based, fluorine-based, or molybdenum sulfide-based one; a low-adhesive substrate composed of a fluorine-based polymer such as polytetrafluroroethylene, polychlorotrifluoroethylene, polyvinyl fluoride, polyvinylidene fluoride, a tetrafluoroethylene/hexafluoropropylene copolymer, or a chlorofluoroethylene/vinylidene fluoride copolymer; a low-adhesive substrate composed of a non-polar polymer, e.g., an olefinic resin such as polyethylene or polypropylene; or the like. Moreover, if necessary, in order to prevent the active energy ray-curable pressure-sensitive adhesive layer from curing by environmental ultraviolet rays, the separator may have undergone an ultraviolet-preventing treatment.

The thickness of the separator is not particularly limited but, for example, is 10 to 20 $\mu$m, preferably about 25 to 100 $\mu$m.

In the case where the pressure-sensitive adhesive sheet for dicing of the invention is a double-sided pressure-sensitive adhesive sheet, the above separator may be provided on both sides of the pressure-sensitive adhesive sheet, or a separator having a backside release layer is provided on one pressure-sensitive adhesive surface and the sheet may be wound up so that the backside release layer of the separator comes into contact with the pressure-sensitive adhesive surface present on the opposite side.

Dicing method

A method of dicing an adherend in which the pressure-sensitive adhesive sheet for dicing according to the invention is used will be described with reference to the case where a semiconductor wafer is used as the adherend.

A series of steps for dicing the semiconductor wafer comprises a mounting step, a dicing step, and a pickup step. The mounting step is a step of attaching the semiconductor wafer to the pressure-sensitive adhesive sheet for dicing. As an attaching method, for example, there is a method including superposing the semiconductor wafer and the pressure-sensitive adhesive sheet in such a manner that the active energy ray-curable pressure-sensitive adhesive layer of the pressure-sensitive adhesive sheet contacts with the semiconductor wafer and then pressing the whole with a pressing means such as a pressure roller. In addition, the attachment can also be carried out by superposing the semiconductor wafer and the pressure-sensitive adhesive sheet as described above in a container where a pressure can be applied (e.g., an autoclave or the like), and then applying a pressure to the inside of the container. In this process, the attachment may be performed while a pressure is applied by a suitable pressing means. Furthermore, the attachment may be performed in a vacuum chamber in the same manner as mentioned above. The temperature during the attachment is not particularly limited but is preferably 20 to 80°C. In the mounting step, when the pressure-sensitive adhesive sheet for dicing according to the invention is used, the sheet has a strong adhesiveness to the semiconductor wafer and can be easily attached to the semiconductor wafer.

The dicing step is a step of dicing the semiconductor wafer to produce semiconductor chips. The dicing is performed according to conventional techniques. Since the active energy ray-curable pressure-sensitive adhesive layer in the pressure-sensitive adhesive sheet for dicing according to the invention has a gel fraction of 50% or more before irradiation with an active energy ray, cohesive force of the pressure-sensitive adhesive is high and hence, when the pressure-sensitive adhesive sheet according to the invention is used, rolling-up of the pressure-sensitive adhesive in the case of using a round blade at the dicing step can be prevented and thus the adhesive residue to be left on the chips can be prevented. Therefore, the sheet can be suitably used in the method wherein the semiconductor wafer is cut from both circuit surfaces of the semiconductor wafer into a predetermined size with a round blade containing diamond particles at a high rotating speed. Moreover, as a cutting method, there can be adopted the so-called full-cut method wherein the active energy ray-curable pressure-sensitive adhesive layer is cut as well. The dicing device is not particularly limited and any conventional dicing device may be used. In the dicing step, when the pressure-sensitive adhesive sheet for dicing according to the invention is used, the semiconductor wafer is bonded and fixed with the pressure-sensitive adhesive sheet, so that chipping and sputtering of chips and also breakage of the semiconductor wafer can be suppressed. Furthermore, the adhesive residue to be left on the semiconductor chips is prevented and thus production efficiency can be improved.

The pickup step of the semiconductor chips is a step of peeling the semiconductor chips bonded and fixed to the pressure-sensitive adhesive sheet for dicing. The pickup method is not particularly limited and any conventionally known method may be adopted. For example, there may be mentioned a method including pushing each semiconductor chip upward from the pressure-sensitive adhesive sheet side by means of a needle and then picking up the pushed semiconductor chip with a pickup device. When the pressure-sensitive adhesive sheet for dicing according to the invention is used, the chips can be easily peeled and collected from the pressure-sensitive adhesive sheet without fouling the adherend in the pickup step.

In the dicing method according to the invention, the active energy ray-curable pressure-sensitive adhesive layer of the pressure-sensitive adhesive sheet for dicing is irradiated with an active energy ray after the dicing step and before the pickup step. By the irradiation with an active energy ray, the active energy ray-curable pressure-sensitive adhesive is cured to remarkably lower the adhesive strength and the chips can be easily peeled from the pressure-sensitive adhesive sheet without fouling the adherend in the pickup step. The irradiation conditions such as irradiation intensity and irradiation time at the irradiation with an active energy ray are not particularly limited and can be suitably set according to the necessity. Moreover, after the irradiation with an active energy ray, in order to broaden the distance between the cut adherends to facilitate the pickup of the adherends, expanding of the pressure-sensitive adhesive sheet for dicing is performed. On that occasion, when the ring part fixing the pressure-sensitive adhesive sheet for dicing is irradiated with the active energy ray, there is a possibility that the pressure-sensitive adhesive sheet peels from the ring (ring detachment) and thus pickup becomes impossible. Therefore, by blocking the irradiation of the ring part with an active energy ray, the peeling can be prevented. When the pressure-sensitive adhesive sheet for dicing according to the invention is used, the pressure-sensitive adhesive sheet does not peel from the ring even at the expanding for broadening the distance between the semiconductor chips after dicing. In addition, after completion of the expanding step, also at the ring part which is not irradiated with an active energy ray, the pressure-sensitive adhesive sheet can be easily peeled from the ring without occurrence of cohesive failure of the pressure-sensitive adhesive and thus no paste residue is left on the ring.

In the above, the pressure-sensitive adhesive sheet for dicing according to the invention is described with reference to the case where a semiconductor wafer is used as an adherend. However, the invention is not limited thereto and it can be also used for the dicing of semiconductor packages, glass, ceramics, and the like.

Examples

The following will more specifically describe the invention with reference to Examples but the invention is not limited to these Examples.

Example 1

A 70 $\mu$m-thick film made of linear low-density polyethylene was used as a substrate. One side of the film was subjected to a corona treatment.

Moreover, 60 parts by weight of methyl acrylate, 30 parts by weight of 2-ethylhexyl acrylate, and 10 parts by weight of 2-hydroxyethyl acrylate were mixed to prepare a monomer solution.

Nitrogen was introduced into a reaction vessel fitted with a nitrogen-inlet tube, a thermometer, and a stirrer and then 400 g of ethyl acetate, 60 g of methyl acrylate, 30 g of 2-ethylhexyl acrylate, 10 g of acrylic acid, and 0.2 g of AIBN (azobisisobutyronitrile) were charged under a nitrogen atmosphere, followed by stirring at 60°C for 24 hours. Thereafter, the whole was cooled to room temperature to obtain an acrylic copolymer solution 1 containing an acrylic copolymer (weight-average molecular weight: 600,000).

To the above acrylic copolymer solution 1 were added 40 parts by weight of an ultraviolet-curable oligomer (viscosity at 25°C: 10 Pa·sec) obtained by reacting pentaerythritol triacrylate with diisocyanate in equivalent amounts, 3 parts by weight of a photopolymerization initiator (trade name "Irgacure 651 ", manufactured by Ciba Specialty Chemicals Co.), and 3 parts by weight of a polyisocyanate compound (trade name "Coronate L", manufactured by Nippon Polyurethane Co., Ltd.), thereby obtaining an ultraviolet-curable acrylic pressure-sensitive adhesive solution 1.

The above ultraviolet-curable acrylic pressure-sensitive adhesive solution 1 was applied on a release agent-treated surface of a separator (trade name "Cerapeel", manufactured by Toray Advanced Film Co., Ltd.) so as to result in a thickness after drying of 5 $\mu$m, and the whole was heated at 80°C for 10 minutes to effect crosslinking, thereby obtaining an ultraviolet-curable pressure-sensitive adhesive layer. Then, the corona-treated surface of the above-mentioned film was attached to the surface of the resulting ultraviolet-curable pressure-sensitive adhesive layer to prepare an ultraviolet-curable pressure-sensitive adhesive sheet for dicing (pressure-sensitive adhesive sheet for dicing 1).

Example 2

An acrylic copolymer solution 2 containing an acrylic copolymer having a carbon-carbon double bond at the end thereof and having a weight-average molecular weight of 600,000 was obtained by adding 12 parts by weight of 2-methacryloyloxyethylene isocyanate to the same acrylic copolymer solution 1 as in Example 1 and reacting them to incorporate an NCO group into 90% of the OH group at the terminal of the side chain of 2-hydroxyethyl acrylate in the copolymer.

Then, to the acrylic copolymer solution 2 were added 20 parts by weight of an ultraviolet-curable oligomer (viscosity at 25°C: 10 Pa·sec) obtained by reacting pentaerythritol triacrylate with diisocyanate in equivalent amounts, 2 parts by weight of a photopolymerization initiator (trade name "Irgacure 651 ", manufactured by Ciba Specialty Chemicals Co.), and 3 parts by weight of a polyisocyanate compound (trade name "Coronate L", manufactured by Nippon Polyurethane Co., Ltd.), thereby obtaining an ultraviolet-curable acrylic pressure-sensitive adhesive solution 2.

The ultraviolet-curable acrylic pressure-sensitive adhesive solution 2 was applied on a release agent-treated surface of a separator (trade name "Cerapeel", manufactured by Toray Advanced Film Co., Ltd.) so as to result in a thickness after drying of 5 μm, and the whole was heated at 80°C for 10 minutes to effect crosslinking, thereby obtaining an ultraviolet-curable pressure-sensitive adhesive layer. Then, the corona-treated surface of the above-mentioned film was attached to the surface of the resulting ultraviolet-curable pressure-sensitive adhesive layer to prepare an ultraviolet-curable pressure-sensitive adhesive sheet for dicing (pressure-sensitive adhesive sheet for dicing 2).

Comparative Example 1

To the same acrylic copolymer solution 1 containing the acrylic copolymer (weight-average molecular weight: 600,000) as in Example 1 were added 120 parts by weight of an ultraviolet-curable oligomer (viscosity at 25°C: 10 Pa·sec) obtained by reacting pentaerythritol triacrylate with diisocyanate in equivalent amounts, 3 parts by weight of a photopolymerization initiator (trade name "Irgacure 651", manufactured by Ciba Specialty Chemicals Co.), and 3 parts by weight of a polyisocyanate compound (trade name "Coronate L", manufactured by Nippon Polyurethane Co., Ltd.), thereby obtaining an ultraviolet-curable acrylic pressure-sensitive adhesive solution 3.

The ultraviolet-curable acrylic pressure-sensitive adhesive solution 3 was applied on a release agent-treated surface of a separator (trade name "Cerapeel", manufactured by Toray Advanced Film Co., Ltd.) so as to result in a thickness after drying of 5 μm, and the whole was heated at 80°C for 10 minutes to effect crosslinking, thereby obtaining an ultraviolet-curable pressure-sensitive adhesive layer. Then, the corona-treated surface of the above-mentioned film was attached to the surface of the resulting ultraviolet-curable pressure-sensitive adhesive layer to prepare an ultraviolet-curable pressure-sensitive adhesive sheet for dicing (pressure-sensitive adhesive sheet for dicing 3).

Comparative Example 2

To the same acrylic copolymer solution 1 containing the acrylic copolymer (weight-average molecular weight: 600,000) as in Example 1 were added 120 parts by weight of an ultraviolet-curable oligomer (viscosity at 25°C: 10 Pa·sec) obtained by reacting pentaerythritol triacrylate with diisocyanate in equivalent amounts, 3 parts by weight of a photopolymerization initiator (trade name "Irgacure 651 ", manufactured by Ciba Specialty Chemicals Co.), and 0.3 parts by weight of a polyisocyanate compound (trade name "Coronate L", manufactured by Nippon Polyurethane Co., Ltd.), thereby obtaining an ultraviolet-curable acrylic pressure-sensitive adhesive solution 4.

The ultraviolet-curable acrylic pressure-sensitive adhesive solution 4 was applied on a release agent-treated surface of a separator (trade name "Cerapeel", manufactured by Toray Advanced Film Co., Ltd.) so as to result in a thickness after drying of 5 μm, and the whole was heated at 80°C for 10 minutes to effect crosslinking, thereby obtaining an ultraviolet-curable pressure-sensitive adhesive layer. Then, the corona-treated surface of the above-mentioned film was attached to the surface of the resulting ultraviolet-curable pressure-sensitive adhesive layer to prepare an ultraviolet-curable pressure-sensitive adhesive sheet for dicing (pressure-sensitive adhesive sheet for dicing 4).

Method for measuring physical properties and method for evaluating effects

The following will describe the measuring method and the method for evaluating effects, which are used in the present application.

(Gel fraction)

Each of the ultraviolet-curable acrylic pressure-sensitive adhesive solutions obtained in Examples and Comparative Examples was applied on a separator (trade name "Cerapeel", manufactured by Toray Advanced Film Co.,

Ltd.) so as to result in a thickness after drying of 5 μm, thereby obtaining a pressure-sensitive adhesive layer. The resulting pressure-sensitive adhesive layer was cut into a size of 100 mm×100 mm in a state where the separator was attached, and the weight (w1) was measured. Then, the separator was stripped off and the weight of the separator (w2) was measured to determine the weight of the pressure-sensitive adhesive layer alone (w1 - w2). The pressure-sensitive adhesive layer was then curled up and wrapped with a Teflon (registered trademark) sheet to prepare a test piece. The test piece wrapped with the Teflon (registered trademark) sheet was immersed in ethyl acetate at 23°C under an atmosphere of 50RH% for 7 days and then the test piece was taken out. After the taken-out test piece was dried at 130°C for 2 hours by means of a hot-air dryer, the weight of the test piece (w3) was measured. The gel fraction was calculated in accordance with the following equation and evaluated according to the following standard.

$$\text{Gel Fraction (\%)} = \{w3/(w1 - w2)\} \times 100$$

Evaluation standard
Gel fraction of 50% or more: A
Gel fraction of less than 50%: B


(Adhesive residue left on chips)

Each of the pressure-sensitive adhesive sheets for dicing obtained in Examples and Comparative Examples was attached to a ground surface of a semiconductor wafer of 6-inch (thickness: 30 μm) subjected to grinding by reciprocating a pressure roller twice at 23°C under an atmosphere of 50RH%. Then, the semiconductor wafer was diced under the following conditions to obtain semiconductor chips.
Dicing conditions
Dicing device: trade name "DFD-651 ", manufactured by DISCO Corp.
Blade: trade name "27HECC", manufactured by DISCO Corp.
Blade rotation number: 40,000 rpm
Dicing rate: 120 mm/sec
Dicing depth: 25 μm
Cutting mode: down cutting
Dicing size: 5.0 mm x 5.0 mm
Then, irradiation with an ultraviolet ray was performed from the backside of the sheet (irradiation time: 20 seconds, irradiation intensity: 500 mJ/cm$^2$). Furthermore, 50 pieces of the semiconductor chips were arbitrarily picked up under the following conditions and were evaluated according to the following standard.
Pickup conditions
Pickup device: trade name "SPA-300", manufactured by Shinkawa Ltd.
Number of pins: 4 pins
Distance between pins: 3.5 mm x 3.5 mm
Curvature of end of pin: 0.250 mm
Pushed height with pin: 0.50 mm
Adsorption-retaining time: 0.2 second
Expanded distance: 5 mm
Evaluation standard
Pickup of all semiconductor chips is successful: A
A case of failed pickup of semiconductor chips exists: B
Then, the chips were observed on a microscope. The number of chips to which the pressure-sensitive adhesive was attached was counted and evaluation was performed according to the following standard.

Evaluation standard

Number of chips to which pressure-sensitive adhesive is attached is less than 5: A
Number of chips to which pressure-sensitive adhesive is attached is 5 or more: B

(Ring detachment)

Each of the pressure-sensitive adhesive sheets for dicing obtained in Examples and Comparative Examples was placed on a bonding device (trade name "SPA-300", manufactured by Shinkawa Ltd.) under the same conditions as in the above test for adhesive residue left on chips and allowed to stand at 23°C under an atmosphere of 50RH% for 12 hours, and then the state was visually observed. Evaluation was performed according to the following standard.
Evaluation standard
No peeling from ring is observed: A
Peeling from ring is observed: B

(Paste residue left on ring)

Each of the pressure-sensitive adhesive sheets for dicing obtained in Examples and Comparative Examples was attached to a ring for dicing, the whole was allowed to stand at 23°C under an atmosphere of 50RH% for 1 week, and then the sheet was peeled by hand. The surface of the ring after peeling was visually observed and evaluation was performed according to the following standard.

Evaluation standard

No paste residue is observed: A
Paste residue is observed: B
The sheets of Examples 1 and 2 had a gel fraction of 50% or more. Thus, no adhesive residue was left on the chips, and ring detachment and a paste residue left on the ring were not observed. On the other hand, the sheets of Comparative Examples 1 and 2 had a gel fraction of less than 50%. Therefore, a pressure-sensitive adhesive residue was left on the chips, and ring detachment and a paste residue left on the ring were observed. The above results are collectively shown in Table 1.

Table 1

|  | Example 1 | Example 2 | Comparative Example 1 | Comparative Example 2 |
|---|---|---|---|---|
| Gel fraction | 70% | 82% | 42% | 18% |
|  | A | A | B | B |
| Adhesive residue left on chips | A | A | B | B |
| Ring detachment | A | A | B | B |
| Paste residue left on ring | A | A | B | B |
| Overall evaluation | Excellent | Excellent | Unsatisfactory | Unsatisfactory |

While the present invention has been described in detail and with reference to specific embodiments thereof, it will be apparent to one skilled in the art that various changes and modifications can be made therein without departing from the scope thereof.
This application is based on Japanese patent application No. 2007-231828 filed September 6, 2007, the entire contents thereof being hereby incorporated by reference.
Further, all references cited herein are incorporated in their entireties.

**Claims**

1. A pressure-sensitive adhesive sheet for dicing comprising a substrate layer and an active energy ray-curable pressure-sensitive adhesive layer provided on the substrate layer,
wherein the active energy ray-curable pressure-sensitive adhesive layer has a gel fraction before irradiation with an active energy ray of 50% or more.

2. The pressure-sensitive adhesive sheet according to claim 1, wherein the active energy ray-curable pressure-sensitive adhesive layer contains an acrylic copolymer having a polymerizable carbon-carbon double bond at a side chain thereof.

3. The pressure-sensitive adhesive sheet according to claim 1, wherein the active energy ray-curable pressure-sensitive adhesive layer contains an acrylic copolymer and an active energy ray-curable oligomer, and
wherein said oligomer is contained in an amount of 1 to 100 parts by weight based on 100 parts by weight of the acrylic copolymer.

4. The pressure-sensitive adhesive sheet according to claim 2, wherein the acrylic copolymer contained in the active energy ray-curable pressure-sensitive adhesive layer has a weight-average molecular weight of 300,000 or more.

5. The pressure-sensitive adhesive sheet according to claim 3, wherein the acrylic copolymer contained in the active energy ray-curable pressure-sensitive adhesive layer has a weight-average molecular weight of 300,000 or more.

6. The pressure-sensitive adhesive sheet according to claim 2, wherein the active energy ray-curable pressure-sensitive adhesive layer contains 0.5 to 10 parts by weight of a crosslinking agent based on 100 parts by weight of the acrylic copolymer.

7. The pressure-sensitive adhesive sheet according to claim 3, wherein the active energy ray-curable pressure-sensitive adhesive layer contains 0.5 to 10 parts by weight of a crosslinking agent based on 100 parts by weight of the acrylic copolymer in the active energy ray-curable pressure-sensitive adhesive layer.

8. A method for dicing an adherend, which comprises attaching the pressure-sensitive adhesive sheet for dicing according to claim 1 to an adherend, followed by cutting the adherend using a round blade.

9. The method for dicing an adherend according to claim 8, wherein the active energy ray-curable pressure-sensitive adhesive layer contains an acrylic copolymer having a polymerizable carbon-carbon double bond at a side chain thereof.

10. The method for dicing an adherend according to claim 8, wherein the active energy ray-curable pressure-sensitive adhesive layer contains an acrylic copolymer and an active energy ray-curable oligomer, and
wherein said oligomer is contained in an amount of 1 to 100 parts by weight based on 100 parts by weight of the acrylic copolymer.

11. The method for dicing an adherend according to claim 9, wherein the acrylic copolymer contained in the active energy ray-curable pressure-sensitive adhesive layer has a weight-average molecular weight of 300,000 or more.

12. The method for dicing an adherend according to claim 10, wherein the acrylic copolymer contained in the active energy ray-curable pressure-sensitive adhesive layer has a weight-average molecular weight of 300,000 or more.

13. The method for dicing an adherend according to claim 9, wherein the active energy ray-curable pressure-sensitive adhesive layer contains 0.5 to 10 parts by weight of a crosslinking agent based on 100 parts by weight of the acrylic copolymer.

14. The method for dicing an adherend according to claim 10, wherein the active energy ray-curable pressure-sensitive adhesive layer contains 0.5 to 10 parts by weight of a crosslinking agent based on 100 parts by weight of the acrylic copolymer.

# *FIGURE*

Europäisches
Patentamt

European
Patent Office

Office européen
des brevets

**EUROPEAN SEARCH REPORT**

Application Number

EP 08 01 5713

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 157 508 A (NITTO ELECTRIC IND CO [JP]) 9 October 1985 (1985-10-09) * page 6, line 15 - page 7, line 20 * * page 9, line 4 - page 10, line 4; claims 1,5-10,13; examples 1-3; table 1 * ----- | 1-14 | INV. C09J7/02 |
| X | EP 1 591 504 A (FURUKAWA ELECTRIC CO LTD [JP]) 2 November 2005 (2005-11-02) * paragraph [0026]; claims 1,2; examples 1-4; table 1 * ----- | 1,2,4,6, 8,9,11, 13 | |
| X | DATABASE WPI Week 200508 Thomson Scientific, London, GB; AN 2005-068394 XP002511057 & JP 2004 346296 A (NITTO DENKO CORP) 9 December 2004 (2004-12-09) * abstract * ----- | 1,2,4,6, 8,9,11, 13 | |

TECHNICAL FIELDS
SEARCHED (IPC)

C09J

The present search report has been drawn up for all claims

| Place of search | Date of completion of the search | Examiner |
|---|---|---|
| Munich | 26 January 2009 | Sperry, Pascal |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.......................................................................................
& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 08 01 5713

This annex lists the patent family members relating to the patent documents cited in  the above-mentioned European search report.
The members are as contained in the European Patent Office EDP file on
The European Patent Office is in no way liable for these particulars which are merely given for the purpose of information.

26-01-2009

| Patent document cited in search report | | Publication date | Patent family member(s) | | Publication date |
|---|---|---|---|---|---|
| EP 0157508 | A | 09-10-1985 | DE | 3586329 D1 | 20-08-1992 |
| | | | DE | 3586329 T2 | 10-12-1992 |
| | | | JP | 1940230 C | 09-06-1995 |
| | | | JP | 6016524 B | 02-03-1994 |
| | | | JP | 60196956 A | 05-10-1985 |
| EP 1591504 | A | 02-11-2005 | CN | 1748012 A | 15-03-2006 |
| | | | WO | 2004069951 A1 | 19-08-2004 |
| | | | KR | 20050097979 A | 10-10-2005 |
| | | | US | 2008299345 A1 | 04-12-2008 |
| | | | US | 2005249909 A1 | 10-11-2005 |
| JP 2004346296 | A | 09-12-2004 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2187478 A
- JP 56061468 A
- JP 61174857 A
- JP 63017981 A
- JP 56013040 A
- JP 2007231828 A